Europäisches Patentamt

European Patent Office

Office européen des brevets

(11) Publication number: **0 289 173**
**A1**

# EUROPEAN PATENT APPLICATION

(21) Application number: 88303394.6

(22) Date of filing: **14.04.88**

(51) Int. Cl.⁴: **C23C 28/00 , C23C 14/02**

(30) Priority: **30.04.87 GB 8710296**

(43) Date of publication of application:
**02.11.88 Bulletin 88/44**

(84) Designated Contracting States:
**BE DE FR GB IT NL SE**

(71) Applicant: **The British Petroleum Company p.l.c.**
**Britannic House Moor Lane**
**London EC2Y 9BU(GB)**

(72) Inventor: **Gibbs, Nigel Keith**
**The British Petroleum Company p.l.c.**
**Chertsey Road**
**Sunbury-on-Thames Middlesex TW16 7LN(GB)**

(74) Representative: **Scott, Susan Margaret et al**
**BP INTERNATIONAL LIMITED Patents & Agreements Division Chertsey Road**
**Sunbury-on-Thames Middlesex TW16 7LN(GB)**

(54) Wear-resistant coated object.

(57) An object comprising a substrate provided with a composite wear-resistant coating, said coating comprising a series of layers of titanium nitride, interspersed with alternate layers of titanium, the total thickness of the composite coating being at least 10 microns.

EP 0 289 173 A1

## 0 289 173

## WEAR-RESISTANT COATED OBJECT

The present invention relates to a wear resistant coated object and a method for its preparation.

Tough wear resistant coatings on the surface of substrates and bulk materials are most desirable where such surfaces are likely to experience abrasion, fatigue or corrosion wear.

The wear performance of many known wear resistant coatings on steel substrates, for example chromium plating, electroless nickel and sprayed tungsten carbide, is limited by their hardness, hardness being resistance to permanent plastic deformation. The useful thicknesses of these types of coatings range from 25 to 500 microns.

Engineering ceramics, for example alumina, silicon carbide and titanium nitride, have higher hardnesses than such coatings and could in principle therefore provide much greater wear resistance. But ceramic coatings, which are usually deposited by physical vapour deposition (PVD) methods, cannot be deposited on steels at thicknesses greater than about 5-10 microns. This is because the coatings have low toughness or resistance to crack propagation. This causes the coatings to crack and spall from the substrate under residual stresses. The residual stresses are caused by thermal mismatch stresses between the coating and the substrate. The thicknesses which can be deposited are inadequate to give the substrate a long life in a hostile environment.

It has now been found that if, instead of applying a coating of one or more ceramic layers directly on the substrate, layers of titanium nitride are interleaved by layers of metallic titanium, thick wear resistant coatings with desirable properties can be produced.

Accordingly, the present invention provides an object comprising a substrate provided with a composite wear resistant coating, said coating comprising a series of layers of titanium nitride, interspersed with alternate layers of titanium, the total thickness of the composite coatings being at least 10 microns.

In one embodiment of the present invention, the composite coating comprises a series of layers of titanium nitride increasing in thickness in each successive layer in one direction, interspersed with alternate layers of titanium of decreasing thickness in successive layers in the same direction, the surface layer being composed of titanium nitride.

Each layer of titanium nitride is preferably at least 1.1 microns thick, preferably from 0.1 to 20, especially 0.5 to 10, and most preferably 1 to 5, microns thick. Each layer of titanium is preferably at least 0.01 microns thick, preferably from 0.01 to 20 especially 0.1 to 10, and most preferably 1 to 5, microns thick.

The thicknesses of the layers of titanium nitride and the interleaving layers of titanium can be the same of different.

It is preferable that the thickness of each layer of titanium is less than that of the adjoining layers of the titanium nitride on either side.

The composite coatings has a thickness of at least 10 microns, suitably from 10-200, especially 10-100, microns.

The coating includes a minimum of two, preferably three, layers each of titanium nitride and titanium. The maximum number of layers depends only on practical considerations. Up to a hundred layers each of titanium and titanium nitride can readily be provided.

It should be understood that each titanium layer may comprise pure metal or an alloy.

Preferably the layer immediately adjacent the substrate is a titanium layer, and the surface layer is a titanium nitride layer. Thus, a specific example would be where the initial titanium layer nearest the substrate surface would be about 1 micron thick and would gradually decrease in thickness between alternate layers of TiN to about 100 Angstroms as the wear resistance surface layer approaches. Correspondingly, the thickness of the TiN layer would gradually increase in thickness from e.g. 1 micron nearest the substrate surface to about 5 microns at the wear resistant surface layer. The net effect of this would be to have a composite coating which has a thickness of at least 10 microns.

It should be understood that, under some conditions, from the substrate to the wear resistant surface there may be a gradual and continuous transition from the predominantly titanium metal layer through a series of complex phases of nitrides such as the hexagonal $Ti_2N$ phase to the final cubic TiN phase. This is due to the possibility of nitrogen diffusing from the TiN layer into the adjacent Ti metal layers in the composite coatings of the present invention.

Any suitable substrate may be coated according to the invention. Suitable metallic substrates include steel, nickel-and cobalt-based materials, titanium and its alloys, and aluminium. Suitable non-metallic substrates include ceramics and fibres. In preferred objects according to the invention, the substrate is steel.

The objects of the present invention can be prepared by well known techniques. The present invention further provides a method for making an object according to the invention, which comprises depositing alternate titanium layers and layers of titanium nitride on the surface of the substrate. Physical vapour deposition (PVD) and chemical vapour deposition (CVD) techniques may be used. CDV techniques are described for example in "Vapour Deposition", C.F. Powell et al, Wiley, NY 1966, Sections 9 to 11. PVD techniques are preferred as they allow greater degree of control of the layer thickness. In particular sputtering and evaporation techniques are most suitable.

In the sputtering technique the material to be deposited is removed from an electrode by induced ion bombardment, the ions being drawn from a glow discharge excited in a soft vacuum using an inert gas. The gas discharge may be initiated either by applying a high direct current potential across electrodes in a soft vacuum (about $5 \times 10^{-2}$ to $10^{-1}$ torr) containing an inert gas and is the so called "D.C. Diode Sputtering".

Alternatively, a radio frequency field can be applied on the material which results in a glow discharge of a different type and is the so called "R.F. Diode Sputtering".

Both these methods are usually operated in a chamber which has been evacuated, using a traditional vacuum pumping technique to a value greater than $10^{-6}$ torr, then back filled with a high purity inert gas (e.g. argon) followed by ionisation of that gas. In the case of the Ti and TiN system, the gas will be nitrogen.

The material to be sputtered is connected to the electrode and the substrate to be coated is placed on a work table. The substrate surface can be cleaned by ion-bombardment prior to commencement of deposition in order to ensure good adhesion of the coating to the substrate.

The sputtering process is relatively slow and generates only relatively thin coatings and hence the so called "magnetron" system is used for increased deposition rates and thicker coatings. In this case, the chance of ionisation of the material to be sputtered is enhanced by exposing the electrons above the material to a crossed electric-magnetic field. Normally, the ions generated from the material being sputtered would strike the substrate surface. However, in the presence of an electric-magnetic field they move in a path determined by their energy and initial direction, usually helical. This technique not only facilitates further ionisation of the material thereby intensifying the plasma, it also prevents much of the direct bombardment of the substrate by secondary electrons.

Amongst the evaporation techniques may be listed the so called activation reaction evaporation (ARE) process and the biased activation reaction evaporation (BARE) process.

These techniques are described by Bunshah, R.F. et al in J. Vac. Sci. Technol., 9, 1385 (1973) and by Bunshah, R.F. in "Thin Solid Films", So 235 (1981) respectively.

In general these techniques use electron beam evaporation from a molten pool of material. A positive 'probe' electrode is incorporated which draws the emitted electrons thereby increasing ionisation. The presence of the positive electrode makes the specimen cathodic in the resulting gas discharge so that they could be said to be ion plated in that a proportion of the arriving atoms are ions. In BARE, the ARE method is combined with a negative bias on the specimens.

Yet another method of enhancing ionisation of the material as the so called "intrinsic electron beam vapour source ionisation enhancement".

Such a technique is described by Boston, M.E. in "Metallurgia", 248, June 1983.

Objects of the present invention are especially useful in abrasive wear applications, for example, hydraulic piston rams in abrasive liquid environment; gate, ball and choke valves in oil fields; thrust bearing in down-hole turbo drills; mud pump cylinder liners; seals; turbine blades; pump impellers/housings; extrusion dies; thread guides; cutting blades; bearings; machine tools and the like.

The following Examples illustrate the invention. The coated samples used in the Examples were prepared using conventional PVD techniques on a commercial PVD machine, the Techvac IP35L. Because of limitations in the coating technique, the exact dimensions of the coatings varied, but on average, in the Ti/TiN composite coatings, each TiN layer was 0.75 microns thick, and each Ti layer was 0.38 microns thick.

Example 1 - Toughness

Low toughness materials crack easily. Wear leads to material removal by crack propagation and material flaking or chipping off. Increasing coating toughness can significantly reduce material removal.

This can be demonstrated for multilayer TiN/Ti coatings by comparing them to TiN coatings under sliding indenter scratch test conditions. Sliding indenter scratch tests were performed using a Leitz Miniload microhardness tester with a Vickers pyramidal indenter. Tests were made at 50g and 500g indentation loads. The indenter was loaded onto the specimen and the specimen moved manually under the indenter at a constant speed of 30 mm/minute. Comparison of scratch widths at equivalent test loads and coating thicknesses give a clear indication of relative material removal.

| Coating | Thickness (microns) | Scratch Width (microns) | |
|---|---|---|---|
| | | at 50g Load | at 500g Load |
| Multilayer TiN/Ti | 10 | 14 | 110 |
| TiN | 10 | 76 | 330 |

At 50g load the TiN coating exhibits massive fracture. the TiN scratch width is 5.5 times the TiN/Ti width. At 500 grams the TiN/Ti scratch exhibits some fracture behaviour but the massive fracture in the TiN gives a scratch width 3 times the TiN scratch width. The behaviour at 500 grams is significantly influenced by the substrate material as the coating thickness and the scratch depth is a significant proportion of the coating thickness.

Example 2 - Hardness

Hardness when related to wear (e.g. by abrasive sand particles) gives a measure of material removed because of plastic deformation or shear. Higher hardness gives less material removal. Hardness is a complex parameter. Microhardness measurements were made using a Leitz Miniload hardness tester and a Vickers pyramidal indenter. Test loads of 20, 50, 100, 200, 300 and 500 grams were used and 10 indents performed at each load. Hardness values were calculated from the indentation diameter (d) and test load in Newton (i.e. $H = 189 \times F(N) \times 10^3/d^2$). Hardness was then plotted against indentation depth (where the indentation depth is 1/7 of the diameter for Vickers indentor). Hardnesses were then compared at an equivalent indentation depth (ie 1 micron).

| Coating | Thickness | Hardness at 1 micron indentation depth |
|---|---|---|
| TiN | 2 microns | 1250 |
| Chromium plate | 40 microns | 1375 |
| Multilayer TiN/Ti | 10 microns | 1800 |
| Multilayer TiN/Ti | 60 microns | 3175 |
| TiN | 10 microns | 3710 |

60 micron TiN/Ti gives a 2.5 fold advantage over 40 micron chromium. Of the coatings tested, only 10 microns of TiN is harder than 60 microns TiN/Ti, but as illustrated in Example 1 this coating is too brittle for use in practice.

Example 3: Strength and Adhesion

Two rectangular bars of M2 tool steel (60 mm x 25 mm x 7 mm) were PVD ion-plated with titanium nitride and multilayered titanium nitride/titanium respectively, to a thickness of 10 microns each. because of equipment restrictions the TiN specimen was made up of 6 TiN layers. TheTiN/Ti specimen had 9 Ti/TiN double layers. The specimens reached 500°C during coating. On cooling, the TiN specimen fractured and spalled under residual stress build up. The TiN/Ti specimen was totally uncracked.

**Claims**

1. An object comprising a substrate provided with a composite wear-resistant coating, said coating comprising a series of layers of titanium nitride, interspersed with alternate layers of titanium, the total thickness of the composite coating being at least 10 microns.

2. An object as claimed in claim 1, in which the coating comprises a series of layers of titanium nitride increasing in thickness in each successive layer in one direction, interspersed with alternate layers of titanium of decreasing thickness in successive layers in the same direction, the surface layer being comprised of titanium nitride.

3. An object as claimed in either claim 1 or claim 2, in which the layer immediately adjacent the substrate is a layer of titanium, and the surface layer is a titanium nitride layer.

4. An object as claimed in any one of claims 1 to 3, in which the substrate is steel.

5. A method for making an object as claimed in any one of claims 1 to 4, which comprises depositing alternate layers of titanium and layers of titanium nitride on the surface of the substrate.

6. A method as claimed in claim 5, in which the layers are deposited by physical vapour deposition.

## DOCUMENTS CONSIDERED TO BE RELEVANT

| Category | Citation of document with indication, where appropriate, of relevant passages | Relevant to claim | CLASSIFICATION OF THE APPLICATION (Int. Cl. 4) |
|---|---|---|---|
| X | GB-A-2 170 226 (LEYBOLD-HERAEUS GmbH) <br> * Figure 2; page 1, line 64 - page 2, line 6; page 4, lines 8-10; claims 1-4 * <br> --- | 1,3-6 | C 23 C 28/00 <br> C 23 C 14/02 |
| X | EP-A-0 149 024 (MITSUBISHI KINZOKU K.K.) <br> * Page 3, line 29 - page 4, line 3; page 6, lines 5-13; page 7, lines 5-15; claims 4,5 * <br> --- | 1,3,5,6 | |
| X | PATENT ABSTRACTS OF JAPAN, vol. 7, no. 97 (C-163)[1242], 23rd April 1983; & JP-A-58 22 374 (MITSUBISHI KINZOKU K.K.) 09-02-1983 <br> * Abstract * <br> --- | 1,4 | |
| X | GB-A-2 110 246 (VSESOJUZNY NAUCHNO-ISSLEDOVATELSKY INSTRUMENTALNY INSTITUT) <br> * Page 1, lines 10-13; page 2, lines 16-18 * <br> --- | 1,5,6 | |
| | | | TECHNICAL FIELDS SEARCHED (Int. Cl.4) |
| X | PATENT ABSTRACTS OF JAPAN, vol. 7, no. 273 (C-198)[1418], 6th December 1983; & JP-A-58 153 770 (HITACHI KINZOKU K.K.) 12-09-1983 <br> * Abstract * <br> --- | 1,5 | C 23 C |
| A | US-A-4 048 039 (H. DAXINGER) <br> * Column 2, table 1; column 3, table 2 * <br> ----- | 3 | |

The present search report has been drawn up for all claims

| Place of search | Date of completion of the search | Examiner |
|---|---|---|
| THE HAGUE | 22-07-1988 | JOFFREAU P.O. |

EPO FORM 1503 03.82 (P0401)